# EUROPEAN PATENT APPLICATION

(11) **EP 2 772 861 A1**
(43) Date of publication of application: **03.09.2014**
(21) Application number: 14275032.2
(22) Date of filing: 25.02.2014
(51) Int. Cl.: G06F 11/263, G01R 31/3183

(54) **Semiconductor test device and semiconductor test method**

(30) Priority: 27.02.2013 KR 20130021491
(71) Applicant: Samsung Electro-Mechanics Co., Ltd, Suwon, Gyunggi-Do (KR)
(72) Inventor: Torrecampo, Oscar Pedro Banaag, Gyunggi-do (KR)
(74) Representative: Potter Clarkson LLP

(57) **Abstract**

There is provided a semiconductor test device, including: a test information acquisition unit acquiring test information; a test information conversion unit converting the acquired test information into test vector information including a plurality of test vectors; and a test signal generation unit generating a test input signal based on the test vector information.

## Description

### CROSS-REFERENCE TO RELATED APPLICATION

This application claims the benefit of Korean Patent Application No. 10-2013-0021491 filed on February 27, 2013, with the Korean Intellectual Property Office, the disclosure of which is incorporated herein by reference.

### BACKGROUND

The present disclosure relates to a semiconductor test device and a semiconductor test method.

In general, Automatic Test Equipment (ATE) applies a test input signal to a Device Under Test (DUT) and acquires a test output signal corresponding to the test input signal.

The ATE may determine whether the DUT is faulty or not based on the test input signal and the test output signal.

Typically, a test input signal has a low clock frequency. Therefore, such a test input signal with a low clock frequency may result in longer testing times for DUTs when using a semiconductor test device.

Patent Document 1 below discloses a pattern generator to test a DUT, but does not disclose features aimed at improving DUT test speeds.

### [Related Art Document]

(Patent Document 1) Korean Patent Laid-Open Publication No. 2000-0004903

### SUMMARY

An aspect of the present disclosure may provide a semiconductor test device and a semiconductor test method capable of testing a semiconductor device faster.

An aspect of the present disclosure may also provide a semiconductor test device and a semiconductor test method capable of efficiently storing a test input signal.

According to an aspect of the present disclosure, a semiconductor test device may include: a test information acquisition unit acquiring test information; a test information conversion unit converting the acquired test information into test vector information including a plurality of test vectors; and a test signal generation unit generating a test input signal based on the test vector information.

The test vector information conversion unit may convert the test information having a first clock rate into test vector information having a second clock rate faster than the first clock rate.

The test information acquisition unit may acquire a plurality of test information items.

The semiconductor test device may further include: a test vector information storage unit storing the test vector information.

The test vector information storage unit may store a pattern of the test vector therein.

The semiconductor test device may further include: a sense unit acquiring a test output signal in response to the test input signal; and a control unit determining whether a device under test is faulty, based on the test input signal and on the test output signal.

According to another aspect of the present disclosure, a semiconductor test method may include: acquiring test information; converting the acquired test information into test vector information including a plurality of test vectors; and generating a test input signal based on the test vector information.

The converting of the test vector information may include converting the test information having a first clock rate into test vector information having a second clock rate faster than the first clock rate.

The acquiring of the test information may include acquiring a plurality of test information items.

The semiconductor test method may further include storing the test vector information.

The storing of the test vector information may include storing a pattern of the test vector.

The semiconductor test method may further include: acquiring a test output signal in response to the test input signal; and determining whether a device under test is faulty, based on the test input signal and on the test output signal.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a block diagram of a semiconductor test device according to an exemplary embodiment of the present disclosure;
FIG. 2 is a diagram illustrating examples of test information;
FIG. 3 is a diagram illustrating an example of converting test information into test vector information;
FIG. 4 is a diagram illustrating examples of patterns of a test vector; and
FIG. 5 is a flowchart illustrating a semiconductor test method according to an exemplary embodiment of the present disclosure.

### DETAILED DESCRIPTION

Hereinafter, embodiments of the present disclosure will be described in detail with reference to the accompanying drawings. The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art. Throughout the drawings, the same or like reference numerals will be used to designate the same or like elements.

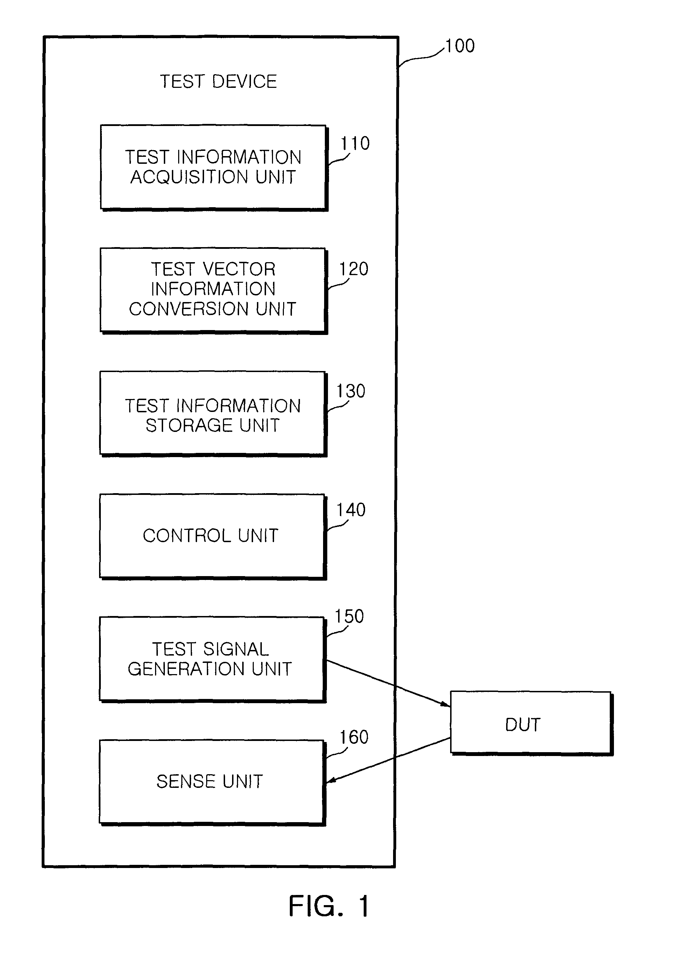

FIG. 1 is a block diagram of a semiconductor test device according to an exemplary embodiment of the present disclosure.

The semiconductor test device 100 may determine whether a DUT is faulty or not.

Referring to FIG. 1, the semiconductor test device 100 may include a test information acquisition unit 110, a test information conversion unit 120, a test vector information storage unit 130, a control unit 140, a test signal generation unit 150, and a sense unit 160.

The test information acquisition unit 110 may acquire test information to be applied to a Device Under Test (DUT). By applying the test information to a DUT, the semiconductor test device 100 may determine whether the DUT is faulty or not.

The test information may be generated by a Test Pattern Generator (TPG) or a simulator. For example, the TPG or the simulator may provide a file format which can be recognized by the test information acquisition unit 110 of the semiconductor test device 100. Such a file format may include a Value Change Dump/extended Value Change Dump (VCD/eVCD) file format from a simulator, a waveform generation language (WGL) file format from a TPG, and standard test interface language (STIL), for example.

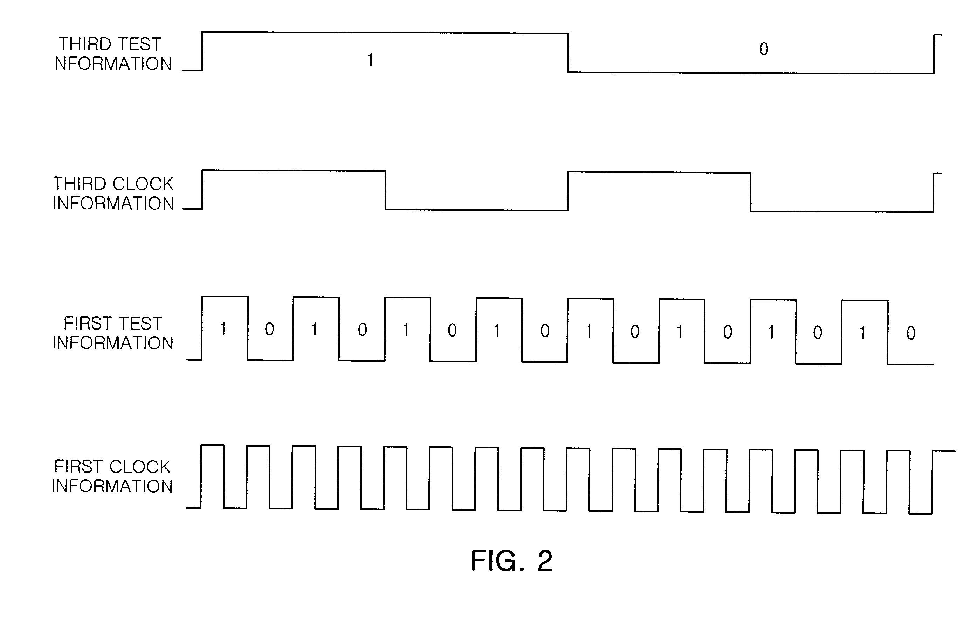

FIG. 2 is a diagram illustrating examples of test information.

As shown in FIG. 2, first test information may be a predetermined waveform.

While the first test information is applied to a DUT, the semiconductor test device 100 may determine whether the DUT is faulty at a rate corresponding to the frequency of first clock information.

That is, the first test information may be applied to the DUT in the form of a digital signal composed of zeros and ones along with the first clock information.

As shown in FIG. 2, third test information may be another predetermined waveform.

While the third test information is applied to a DUT, the semiconductor test device 100 may determine whether the DUT is faulty at a rate corresponding to the frequency of third clock information.

That is, the third test information may be applied to the DUT in the form of a digital signal composed of zeros and ones along with the third clock information.

The test information conversion unit 120 may convert the test information acquired by the test information acquisition unit 110 into test vector information including a plurality of test vectors.

The information contained in the test information may be divided into a predetermined number of vectors. Herein, the vectors each containing the divided information is referred to as test vectors.

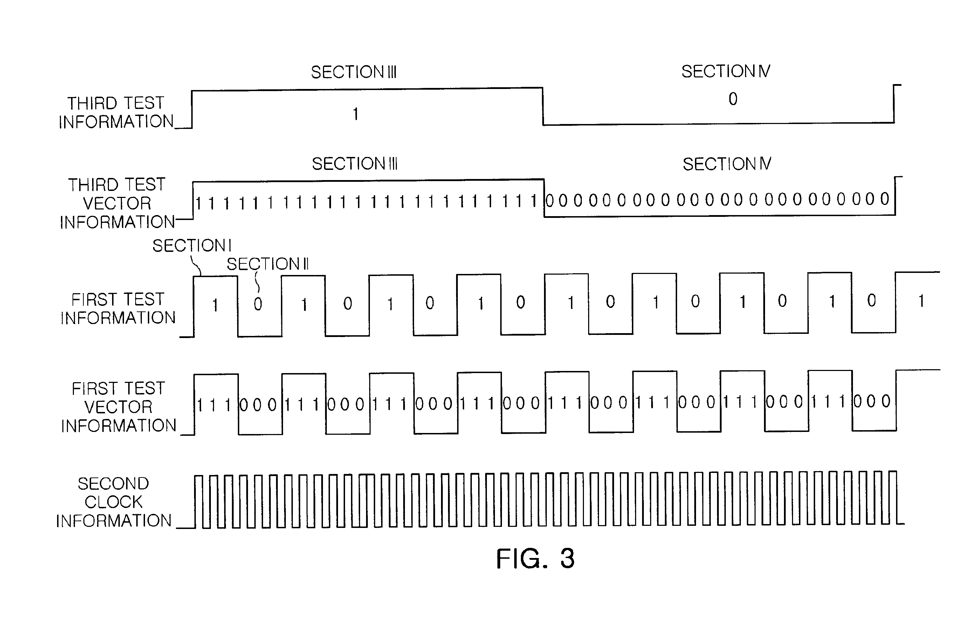

FIG. 3 is a diagram illustrating an example of converting test information into test vector information.

Referring to FIG. 3, the first test information may be converted into first test vector information. For example, Section I in the first test information may be represented by three test vectors, i.e., "111" in the first test vector information. In addition, Section II in the first test information may be represented by three test vectors, i.e., "000" in the first test vector information.

The third test information may be converted into third test vector information. For example, Section III in the third test information may be represented by twenty-four test vectors, i.e., "111...1" in the third test vector information. For example, Section IV in the third test information may be represented by twenty-four test vectors, i.e., "000...0" in the third test vector information.

As described above, sections in the test information may be represented by n test vectors. The number n may be an integer.

According to an exemplary embodiment of the present disclosure, the first test information may be applied to a DUT at a rate corresponding to the frequency of the first clock information (a first clock rate). The semiconductor test device 100 may determine whether the DUT is faulty or not at a rate corresponding to the frequency of the first clock information (the first clock rate).

Further, the third test information may be applied to the DUT at a rate corresponding to the frequency of the third clock information (a third clock rate). The semiconductor test device 100 may determine whether the DUT is faulty or not at a rate corresponding to the frequency of the third clock information (the third clock rate).

The first test vector information and the second test vector information may be applied to the DUT at a rate corresponding to the frequency of second clock information (a second clock rate). Therefore, the semiconductor test device 100 may determine whether the DUT is faulty or not at a rate corresponding to the frequency of the second clock information (the second clock rate).

The second clock rate may be faster than the first and third clock rates. Accordingly, the semiconductor test device 100 may determine whether the DUT is faulty or not faster by converting the first test information and the third test information into the first test vector information and the third vector information, respectively.

Therefore, a waveform corresponding to certain test information may be applied to the DUT at a faster clock rate with the same information.

According to an exemplary embodiment of the present disclosure, the test vector information storage unit 130 may store the test vector information therein.

For example, the test vector information storage unit 130 may store a pattern of the test vector therein.

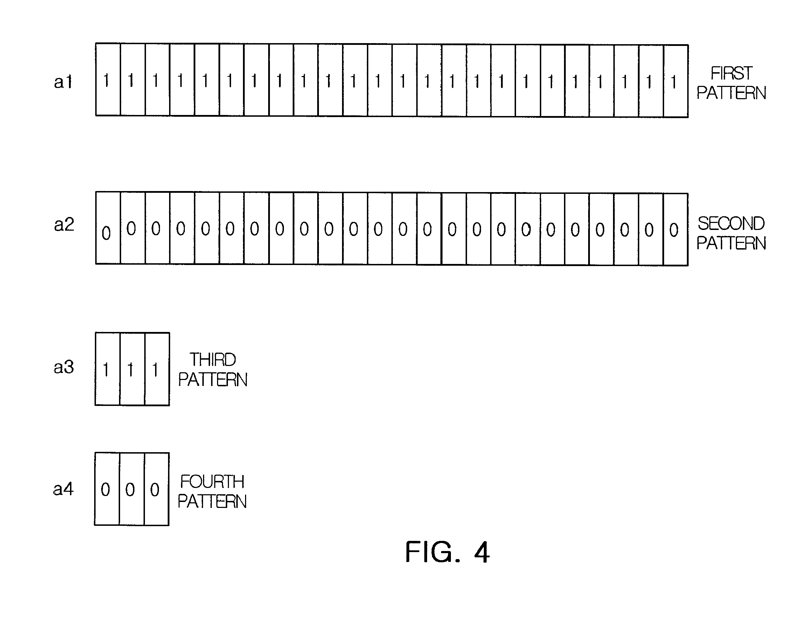

FIG. 4 is a diagram illustrating examples of patterns of a test vector.

For the third test vector information shown in FIG. 3, the test vector information storage unit 130 may store a first pattern and a second pattern.

The storage addresses for the patterns of the test vector may be set. For example, "a1" may be set for the storage address representing the first pattern. In addition, "a2" may be set for the storage address representing the second pattern.

When the third test vector information has a pattern of repeated sections III and sections IV, the test vector information storage unit 130 may require a lot of storage spaces in order to store all of the patterns.

Accordingly, the test vector information storage unit 130 may save the storage spaces by storing only the repeated first and second patterns.

When the semiconductor test device 100 retrieves the third test vector information, the semiconductor test device 100 may alternately retrieve the address at which the first pattern is stored (a1) and the address at which the second pattern is stored (a2).

Further, for the first test vector information shown in FIG. 3, the test vector information storage unit 130 may store a third pattern and a fourth pattern.

The storage addresses for the patterns of the test vector may be set. For example, "a3" may be set for the storage address representing the third pattern. In addition, "a4" may be set for the storage address representing the fourth pattern.

When the first test vector information has a pattern of repeated section I and section II, the test vector information storage unit 130 may require a lot of storage spaces in order to store all of the patterns.

Accordingly, the test vector information storage unit 130 may save the storage spaces by storing only the repeated third and fourth patterns.

When the semiconductor test device 100 retrieves the first test vector information, the semiconductor test device 100 may alternately retrieve the address at which the third pattern is stored (a3) and the address at which the fourth pattern is stored (a4).

The test signal generation unit 150 may generate a test input signal based on the test vector information.

Herein, a signal applied to a DUT by the semiconductor test device 100 to determine whether the DUT is faulty or not is referred to as a test input signal.

The DUT may output a test output signal to the semiconductor test device 100 based on the test input signals.

The test output signal refers to an output pulse signal output from the DUT in response to the test input signal.

The sense unit 160 may acquire a test output signal from the DUT.

The control unit 140 may control the overall operation of the semiconductor test device 100. In particular, the control unit 140 may determine whether the DUT is faulty or not, based on the test input signal and on the test output signal acquired from the DUT.

For example, the control unit 140 may determine whether the DUT is normal or not by comparing the waveform of the test vector information with the waveform of the test output signal.

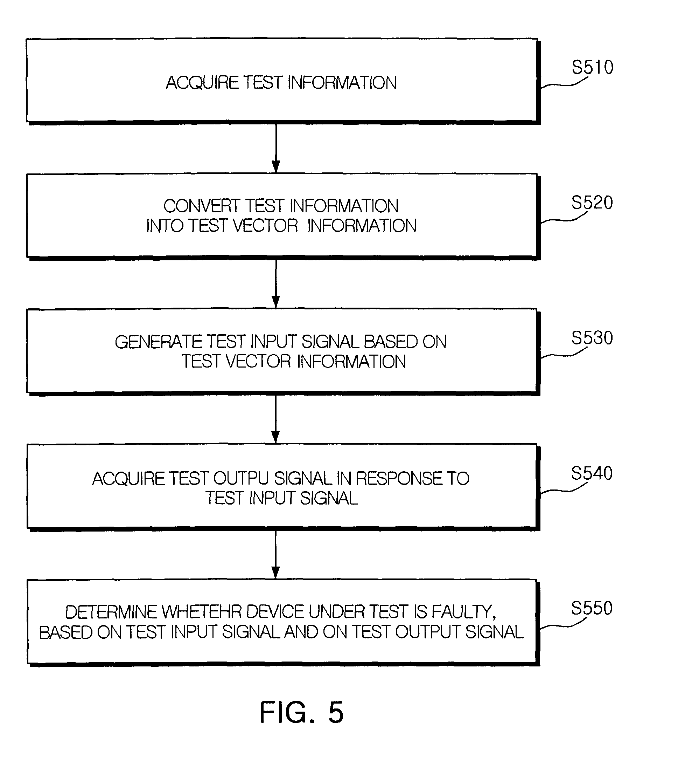

FIG. 5 is a flowchart illustrating a semiconductor test method according to an exemplary embodiment of the present disclosure.

According to an exemplary embodiment of the present disclosure, the test information acquisition unit 110 may acquire test information (S510).

The test information acquisition unit 110 may determine whether the test information is of a format suitable for being used in the semiconductor test device 100.

For example, if the test information acquired by the test information acquisition unit 110 is of a VCD format acquired from a simulator, of a WGL format acquired from a TPG, or of a STIL format, the test information acquisition unit 110 may convert the test information into an ATE ASCII format. Further, if the test information acquired by the test information acquisition unit 110 is an ATE binary format, the test information acquisition unit 110 may convert the test information into an ATE ASCII format.

Further, according to an exemplary embodiment of the present disclosure, the test information conversion unit 120 may convert the test information into test vector information including a plurality of test vectors (S520).

For example, the test vector information storage unit 130 may store the test vector information therein. Specifically, the test vector information storage unit 130 may store a pattern of the test vector therein.

Additionally, the test signal generation unit 150 may generate a test input signal based on the test vector information (S530).

The test input signal may be a binary pattern.

Further, according to an exemplary embodiment of the present disclosure, the sense unit 160 may acquire a test output signal in response to the test input signal (S540).

Moreover, according to an exemplary embodiment of the present disclosure, the control unit 140 may determine whether a DUT is faulty or not based on the test input signal and on the test output signals (S550).

In addition, according to an exemplary embodiment of the present disclosure, the semiconductor test device 100 may acquire a plurality of test information items.

In this case, the semiconductor test device 100 may apply test vector information on to each of the plurality of test information items to a plurality of pins of the DUT.

Alternatively, the semiconductor test device 100 may apply test vector information on each of the plurality of test information items to a plurality of DUTs.

The above-described methods according to the embodiments may be used separately from or in combination with one another. Further, operations in each of the exemplary embodiments may be used separately from or in combination with operations in other exemplary embodiments.

Further, the above-described methods may be implemented, for example, in a recording medium that is readable by a computer or a similar device by using software, hardware or a combination thereof.

When implemented as hardware, exemplary embodiments described above may be implemented using at least one of Application Specific Integrated Circuits (ASICs), Digital Signal Processors (DSPs), Digital Signal Processing Devices (DSPDs), Programmable Logic Devices (PLDs), Field Programmable Gate Arrays (FPGAs), processors, controllers, microcontrollers, microprocessors, and electrical units for performing functions.

When implemented as software, the procedures and functions described herein may be implemented as separate software modules. The software modules may be implemented with software code written in an appropriate programming language. The software code may be stored in a storage unit and may be executed by a processor.

As set forth above, according to exemplary embodiments of the present disclosure, a semiconductor test device and a semiconductor test method capable of testing a semiconductor device faster may be provided.

Further, according to exemplary embodiments of the present disclosure, a semiconductor test device and a semiconductor test method capable of efficiently storing a test input signal may be provided.

While exemplary embodiments have been shown and described above, it will be apparent to those skilled in the art that modifications and variations could be made without departing from the spirit and scope of the present disclosure as defined by the appended claims.

## Claims

1. A semiconductor test device, comprising:
a test information acquisition unit acquiring test information;
a test information conversion unit converting the acquired test information into test vector information including a plurality of test vectors; and
a test signal generation unit generating a test input signal based on the test vector information.

2. The semiconductor test device of claim 1, wherein the test vector information conversion unit converts the test information having a first clock rate into test vector information having a second clock rate faster than the first clock rate.

3. The semiconductor test device of claim 1, wherein the test information acquisition unit acquires a plurality of test information items.

4. The semiconductor test device of claim 1, further comprising a test vector information storage unit storing the test vector information.

5. The semiconductor test device of claim 4, wherein the test vector information storage unit stores a pattern of the test vector.

6. The semiconductor test device of claim 1, further comprising:
a sense unit acquiring a test output signal in response to the test input signal; and
a control unit determining whether a device under test is faulty, based on the test input signal and on the test output signal.

7. A semiconductor test method, comprising:
acquiring test information;
converting the acquired test information into test vector information including a plurality of test vectors; and
generating a test input signal based on the test vector information.

8. The semiconductor test method of claim 7, wherein the converting of the test vector information includes converting the test information having a first clock rate into test vector information having a second clock rate faster than the first clock rate.

9. The semiconductor test method of claim 7, wherein the acquiring of the test information includes acquiring a plurality of test information items.

10. The semiconductor test method of claim 7, further comprising storing the test vector information.

11. The semiconductor test method of claim 10, wherein the storing of the test vector information includes storing a pattern of the test vector.

12. The semiconductor test method of claim 7, further comprising:
acquiring a test output signal in response to the test input signal; and
determining whether a device under test is faulty, based on the test input signal and on the test output signal.
